# EUROPÄISCHE PATENTSCHRIFT

(11) **EP 2 664 933 B1**
(45) Veröffentlichungstag und Bekanntmachung des Hinweises auf die Patenterteilung: **25.06.2014**
(21) Anmeldenummer: 12003838.5
(22) Anmeldetag: 15.05.2012
(51) Int. Cl.: G01R 31/02

(54) **Testgerät, Testsystem und Verfahren zum Testen eines energietechnischen Prüflings**
Test device, test system and method for testing an energy test piece
Appareil de test, système de test et procédé de test d'un objet à tester de production d'énergie

(43) Veröffentlichungstag der Anmeldung: 20.11.2013
(73) Patentinhaber: Omicron electronics GmbH, 6833 Klaus (AT)
(72) Erfinder: Klapper, Ulrich, 6830 Rankweil (AT)
(74) Vertreter: Banzer, Hans-Jörg

(56) Entgegenhaltungen:
- EP-A2- 0 258 023
- GB-A- 836 805
- US-A- 5 083 094
- US-A1- 2002 173 927
- US-B1- 6 504 381

## Beschreibung

Die Erfindung betrifft ein Testgerät, ein Testsystem und ein Verfahren zum Testen eines energietechnischen Prüflings. Insbesondere betrifft die Erfindung ein Testgerät, ein Testsystem und ein Verfahren zum Testen bzw. Überprüfen von Betriebsmitteln in elektrischen Hoch- oder Mittelspannungssystemen, wie beispielsweise Leistungstransformatoren, Strom-/Spannungswandlern, Leistungsschaltern, Generatoren, Motoren oder Kabelsystemen, Schutzrelais, etc.

Moderne Testgeräte für Betriebsmittel in elektrischen Hoch- und Mittelspannungssystemen weisen üblicherweise einen Prozessor oder einen Controller, welcher für ein Testsignal eine gewünschte Signalform, z.B. eine veränderliche Sinussignalform, berechnet, einen Digital/Analog-Wandler zum Umsetzen der somit generierten Signalform in ein analoges Testsignal sowie einen Verstärker zum Verstärken des Testsignals, um somit das Testsignal mit einer gewünschten Amplitude zu erhalten, auf.

Abhängig von der Wahl der in dem jeweiligen Testgerät verwendeten Komponenten ist jedoch der jeweils erzielbare Amplitudenbereich beschränkt. Für bestimmten Anwendungen werden daher in herkömmlichen Testumgebungen separate externe Verstärker verwendet, welche mit dem jeweiligen Testsignal beaufschlagt werden und das somit verstärkte Testsignal an den jeweiligen Prüfling ausgeben. Derartige separate Verstärker, deren Funktion auf die Verstärkerfunktionalität beschränkt ist, erhöhen jedoch die mit dem Testsystem bzw. der Testumgebung verbundenen Kosten.

Die Druckschriften EP 0 258 023 A2 und GB 836 805 A offenbaren ein Testgerät gemäß dem Oberbegriff des Anspruchs 1.

Die Druckschrift US 5,083,094 offenbart eine Schaltung mit einer Kopplung von zwei Verstärkern. Durch die Kopplung der beiden Verstärker wird die am Ausgang der Schaltung abgegebene Leistung gegenüber der Leistung eines Verstärkers somit verdoppelt.

Der vorliegenden Erfindung liegt daher die Aufgabe zugrunde, eine Möglichkeit bereitzustellen, um mit einfachen Mitteln den Einsatzbereich einer Testumgebung zu erhöhen und einen energietechnischen Prüfling mit einem größeren Amplitudenbereich testen zu können.

Diese Aufgabe wird erfindungsgemäß durch ein Testgerät gemäß Anspruch 1 oder Anspruch 5, ein Testsystem gemäß Anspruch 14 und ein Testverfahren gemäß Anspruch 16 gelöst. Die abhängigen Ansprüche definieren vorteilhafte oder bevorzugte Ausführungsformen der Erfindung.

Erfindungsgemäß wird ein Testgerät, welches zum Testen eines energietechnischen Prüflings, insbesondere eines Betriebsmittels eines Mittel- oder Hochspannungssystems, ausgestaltet ist, zum Verstärken eines Testsignals eines anderen Testgeräts verwendet. Der ohnehin in dem zur Erzeugung eines eigenen Testsignals dienenden Signalpfad vorgesehene Verstärker des Testgeräts wird somit als zusätzlicher Verstärker für das Testsignal des anderen Testgeräts eingesetzt. Das Testsignal wird aus dem entsprechenden Signalpfad des anderen Testgeräts an geeigneter Stelle ausgekoppelt und in den Signalpfad des als zusätzlicher Verstärker dienenden Testgeräts eingespeist.

Die beiden Testgeräte können einen weitgehend ähnlichen Aufbau, wie er zuvor beschrieben worden ist, aufweisen. Erforderlich ist lediglich, dass das als zusätzlicher Verstärker dienende Testgerät einen Eingang zum Einspeisen des Testsignals des anderen Testgeräts aufweist, während das andere Testgerät einen separaten Ausgang zum Auskoppeln bzw. Ausgeben des entsprechenden Testsignals aufweist. Vorzugsweise sind beide Testgeräte identisch aufgebaut, wobei jeweils der Eingang bei demjenigen Testgerät, welches das eigentliche Testsignal generiert, und der zusätzliche Ausgang bei demjenigen Testgerät, welches als zusätzlicher Verstärker dient, unbenutzt bleibt.

Das Testgerät, welchem das Testsignal des anderen Testgeräts zugeführt werden kann, kann somit wahlweise als herkömmliches Testgerät zur Erzeugung eines eigenen Testsignals oder in einem "Verstärkermodus" als Verstärker für das Testsignal des anderen Testgeräts betrieben werden.

Wird das Testgerät als Verstärker eingesetzt, kann von diesem Testgerät anstelle des von dem Testgerät üblicherweise erzeugten Testsignals das verstärkte Testsignal des anderen Testgeräts an den Prüfling angelegt werden, wobei von einem oder auch von beiden Testgeräten die Testantwort des Prüflings ausgewertet werden kann. Insgesamt kann somit der zum Testen des Prüflings zur Verfügung stehende Amplituden- bzw. Leistungsbereich im Vergleich zu herkömmlichen Testgeräten mit einfachen Mitteln deutlich erweitert werden, wobei in der Regel durch die beschriebene Vorgehensweise eine Verdopplung des Leistungsbereichs erzielt werden kann. Hierzu wird das in der jeweiligen Testumgebung ohnehin vorhandene weitere Testgerät verwendet. Ein separater und teurer Verstärker ist nicht erforderlich.

Dem im "Verstärkermodus" betrieben Testgerät kann das zu verstärkende Testsignal von dem anderen Testgerät über eine analoge oder eine digitale Schnittstelle, z.B. USB, Ethernet, Ethercat, IEC 61850, zugeführt werden. Vorteilhaft erfolgt die Übertragung des Testsignals über eine digitale Schnittstelle, da in diesem Fall in dem Testgerät eine Kompensation der Laufzeit der digitalen Daten mit verhältnismäßig einfachen Maßnahmen realisiert werden kann, um von beiden Testgeräten eine zeitlich synchrone Ausgabe von Abtastwerten des Testsignals an den Prüfling sicher zu stellen. Aufgrund der Laufzeit des Testsignals über die jeweils implementierte Schnittstelle kann es zwischen dem ursprünglich erzeugten Testsignal und dem von dem im "Verstärkermodus" betriebenen Testgerät verstärkten Testsignal zu unerwünschten Phasenverschiebungen kommen, welche bei einem Testsignal mit einer Frequenz in der Größenordnung von 50Hz einige Grad betragen können. Wird die Laufzeit des Testsignals über die Schnittstelle kompensiert, kann eine theoretisch beliebige Phasengenauigkeit erreicht werden.

Die Laufzeitkompensation kann beispielsweise von einem Benutzer durch Einstellung eines Korrekturwerts an dem im "Verstärkermodus" betriebenen Testgerät vorgenommen werden.

Da jedoch die Laufzeit in der Regel nicht konstant und demzufolge auch nicht bekannt ist, ist es vorteilhaft, wenn bei Verwendung einer digitalen Schnittstelle die Abtastwerte des zu verstärkenden Testsignals mit einer Zeitinformation in Form eines Zeitstempels versehen und übertragen werden, so dass das als Verstärker fungierende Testgerät die einzelnen Abtastwerte zu den jeweils exakt richtigen Zeitpunkten ausgeben kann. Hierzu kann das Testgerät eine integrierte Echtzeituhr aufweisen.

Alternativ oder zusätzlich erfolgt gemäß einem weiteren Ausführungsbeispiel der Erfindung die Laufzeitkompensation durch Verwendung eines in der Norm IEEE 1588 beschriebenen Verfahrens. Ebenso kann die Laufzeitkompensation durch Verwendung einer digitalen Ethercat-Schnittstelle vereinfacht werden, da von dieser Schnittstelle ein zu dem Sender zeitsynchroner Takt erzeugt wird, welcher dazu verwendet werden kann, die einzelnen digitalen Abtastwerte des zu verstärkenden Testsignals auf diesen Takt zu synchronisieren.

Die Erfindung wird nachfolgend anhand bevorzugter Ausführungsbeispiele unter Bezugnahme auf die Zeichnung beschrieben.
Fig. 1 zeigt ein schematisches Schaltbild eines Testsystems zum Testen eines energietechnischen Prüflings gemäß einem Ausführungsbeispiel der Erfindung.
Fig. 2 zeigt ein Schaltbild eines Testsystems zum Testen eines energietechnischen Prüflings gemäß einem weiteren Ausführungsbeispiel der Erfindung.

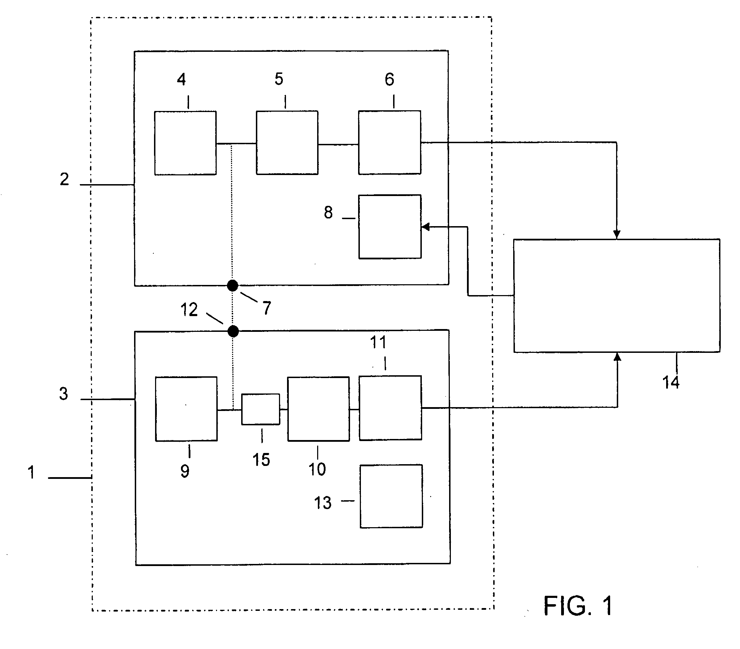

Figur 1 zeigt ein Schaltbild eines Testsystems 1. Das Testsystem 1 umfasst ein erstes Testgerät 2 und ein zweites Testgerät 3. Bei den beiden Testgeräten 2, 3 handelt es sich jeweils um ein Testgerät zum Testen von Betriebsmitteln in elektrischen Hoch- oder Mittelspannungssystemen, wie beispielsweise Leistungstransformatoren, Strom-/Spannungswandlern, Leistungsschalter, Generatoren, Motoren oder Kabelsystemen, Schutzrelais, etc.

Der Aufbau der beiden Testgeräte 2, 3 ist insofern ähnlich, als dass beide Testgeräte eine Testsignal-Erzeugungseinrichtung 4 bzw. 9 in Verbindung mit einem Digital/Analog-Wandler 5 bzw. 10 und einem Verstärker 6 bzw. 11 aufweisen. Die Testsignal-Erzeugungseinrichtungen 4, 9 können einen Mikroprozessor oder Controller umfassen, welcher für das jeweils gewünschte Testsignal die geeignete Signalform, beispielsweise in Form eines veränderlichen Sinussignals, berechnet, welche von dem jeweils nachgeschalteten Digital/Analog-Wandler 5, 10 in ein entsprechendes analoges Testsignal umgesetzt wird. Der Verstärker 6 bzw. 11 verstärkt das jeweilige analoge Testsignal und gibt dieses über einen Ausgang des jeweiligen Testgeräts aus.

Jedes der beiden Testgeräte 2, 3 kann auf diese Weise ein Testsignal zum Testen eines in Fig. 1 schematisch dargestellten Prüflings 14 erzeugen, wobei die Antwort des Prüflings 14 von einer Auswertungseinrichtung 8 bzw. 13 erfasst und auf geeignete Weise ausgewertet werden kann.

Bei dem in Fig. 1 gezeigten Ausführungsbeispiel wird jedoch das zweite Testgerät 3 nicht wie ein "normales" Testgerät ähnlich zu dem Testgerät 2 betrieben, sondern das zweite Testgerät 3 ist derart mit dem Testgerät 2 gekoppelt, dass es in einem "Verstärker"-Modus als Verstärker für das von dem ersten Testgerät 2 erzeugte Testsignal fungiert.

Zu diesem Zweck weist das erste Testgerät 2 einen separaten Ausgang 7 auf, um das Testsignal an einer geeigneten Stelle aus dem Signalpfad des Testgeräts 2 auszukoppeln, während das zweite Testgerät 3 einen separaten Eingang 12 aufweist, um das von dem ersten Testgerät 2 empfangene Testsignal in den eigenen Signalpfad mit dem Verstärker 11 einzuspeisen. Bei dem in Fig. 1 gezeigten Ausführungsbeispiel erfolgt die Auskopplung des Testsignals in dem ersten Testgerät 2 zwischen der Testsignal-Erzeugungseinrichtung 4 und dem Digital/Analog-Wandler 5, so dass entsprechend die Einspeisung des Testsignals in den Signalpfad des zweiten Testgeräts 3 zwischen der (im "Verstärker"-Modus inaktiven) Testsignal-Erzeugungseinrichtung 9 und dem Digital/Analog-Wandler 10 erfolgt.

Das auf diese Weise dem zweiten Testgerät 3 zugeführte Testsignal des ersten Testgeräts 2 wird somit von dem Digital/Analog-Wandler 10 des zweiten Testgeräts 3 in ein entsprechendes analoges Signal umgesetzt und von dem Verstärker 11 verstärkt, um mit der gewünschten Amplitude an den Prüfling 14 ausgegeben zu werden.

Von beiden Testgeräten 2, 3 wird somit dasselbe Testsignal an den Prüfling angelegt, wobei das zweite Testgerät 3 lediglich als Verstärker für das von dem ersten Testgerät 2 erzeugte Testsignal fungiert. Die Testsignalantwort des Prüflings 14 kann im Prinzip von beiden Testgeräten ausgewertet werden, wobei jedoch gemäß Fig. 1 davon ausgegangen wird, dass die Auswertung der Testsignalantwort des Prüflings 14 durch die Auswertungseinrichtung 8 des ersten Testgeräts erfolgt.

Dem im "Verstärkermodus" betrieben zweiten Testgerät 3 kann das zu verstärkende Testsignal von dem Testgerät 2 mittels der Anschlüsse 7 und 12 über eine analoge oder eine digitale Schnittstelle, z.B. eine USB-Schnittstelle, eine Ethernet-Schnittstelle, eine Ethercat-Schnittstelle, oder eine Schnittstelle gemäß dem IEC 61850-Standard, zugeführt werden. Vorteilhaft erfolgt die Übertragung des Testsignals über eine digitale Schnittstelle, da in diesem Fall in dem Testgerät 3 eine Kompensation der Laufzeit der digitalen Daten mit verhältnismäßig einfachen Maßnahmen realisiert werden kann, um von beiden Testgeräten 2, 3 eine zeitliche synchrone Ausgabe von Abtastwerten des Testsignals an den Prüfling 14 sicher zu stellen.

Aufgrund der Laufzeit des Testsignals über die jeweils implementierte Schnittstelle mit den Anschlüssen 7, 12 kann es zwischen dem ursprünglich erzeugten Testsignal des ersten Testgeräts 2 und dem von dem im "Verstärkermodus" betriebenen zweiten Testgerät 3 verstärkten Testsignal zu unerwünschten Phasenverschiebungen kommen. Wird die Laufzeit des Testsignals über die Schnittstelle kompensiert, kann eine theoretisch beliebige Phasengenauigkeit zwischen dem Testsignal des ersten Testgeräts 2 und der von dem zweiten Testgerät 3 erzeugten verstärkten Version dieses Testsignals erreicht werden.

Zu diesem Zweck ist das zweite Testgerät 3 mit einer Laufzeitkompensationseinrichtung 15 ausgestattet, welche bei dem in Fig. 1 gezeigten Ausführungsbeispiel vor dem Digital/Analog-Wandler 10 angeordnet ist, um eine digitale Laufzeitkompensation durchzuführen. Alternativ ist auch eine analoge Laufzeitkompensation, d.h. zwischen dem Digital/Analog-Wandler 10 und dem Verstärker 11, denkbar.

Die Laufzeitkompensation kann beispielsweise von einem Benutzer durch Einstellung eines Korrekturwerts an dem im "Verstärkermodus" betriebenen zweiten Testgerät 3 vorgenommen werden, wobei die Laufzeitkompensationseinrichtung 15 ein entsprechendes Stellglied, beispielsweise ein digitales Potentiometer, umfassen kann, um den jeweils gewünschten Korrekturwert zur Laufzeitkompensation einzustellen. Ebenso kann der Korrekturwert auch softwaremäßig auf das Testsignal angewendet werden. Das mit diesem zeitlichen Korrekturwert beaufschlagte Testsignal wird schließlich von dem Verstärker 11 an den Prüfling 14 ausgegeben.

Da jedoch die Laufzeit in der Regel nicht konstant und demzufolge auch nicht bekannt ist, ist es vorteilhaft, wenn bei Verwendung einer digitalen Schnittstelle von dem ersten Testgerät 2 die Abtastwerte des in dem zweiten Testgerät 3 zu verstärkenden Testsignals mit einer Zeitinformation in Form eines Zeitstempels versehen und übertragen werden, so dass das als Verstärker fungierende zweite Testgerät 3 die einzelnen Abtastwerte zu den jeweils exakt richtigen Zeitpunkten ausgeben kann. Hierzu kann die Laufzeitkompensationseinrichtung 15 des zweiten Testgeräts 3 eine integrierte Echtzeituhr aufweisen, so dass das zweite Testgerät 3 die einzelnen Abtastwerte des Testsignals bezogen auf diese Echtzeituhr zu den jeweils korrekten Zeitpunkten an den Prüfling 14 ausgeben kann.

Ebenso kann die Laufzeitkorrektur durch Verwendung eines in der Norm IEEE 1588 beschriebenen Verfahrens erfolgen.

Gemäß einer weiteren Variante kann die Laufzeitkorrektur durch Verwendung einer digitalen Ethercat-Schnittstelle zwischen den Testgeräten 2 und 3 vereinfacht werden, da von dieser Schnittstelle beim Empfänger ein zu dem Sender zeitsynchroner Takt erzeugt wird, welcher von der Laufzeitkompensationseinrichtung 15 dazu verwendet werden kann, in dem zweiten Testgerät 3 die einzelnen digitalen Abtastwerte des zu verstärkenden Testsignals auf diesen Takt zu synchronisieren.

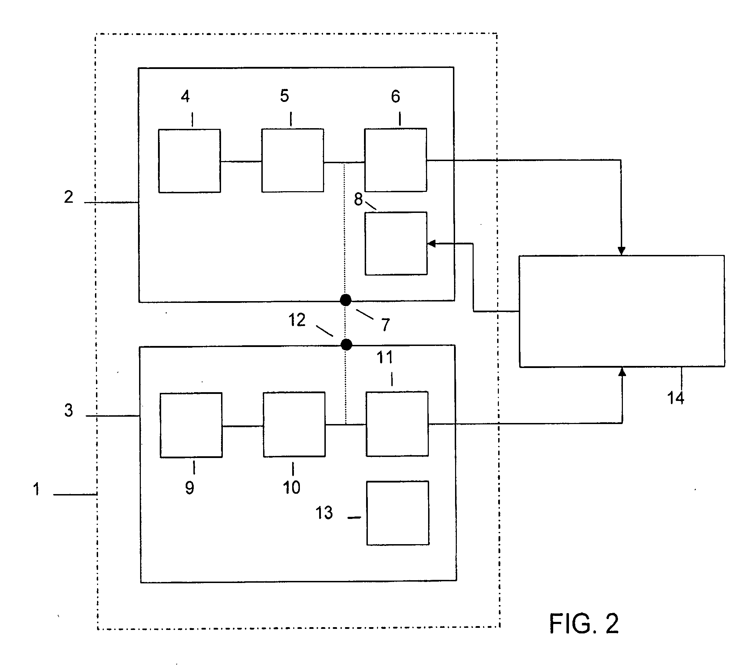

In Fig 2 ist ein weiteres Ausführungsbeispiel eines erfindungsgemäßen Testsystems dargestellt.

Das in Fig. 2 gezeigte Ausführungsbeispiel unterscheidet sich von dem in Fig. 1 gezeigten Ausführungsbeispiel lediglich dadurch, dass gemäß Fig. 2 die Auskopplung des Testsignals über den Ausgang 7 in dem ersten Testgerät 2 zwischen dem Digital/Analog-Wandler 5 und dem Verstärker 6 erfolgt und das ausgekoppelte Testsignal demzufolge über den Eingang 12 zwischen dem Digital/Analog-Wandler 10 und dem Verstärker 11 in den Signalpfad des zweiten Testgeräts 3 eingespeist wird.

Bei der in Fig. 2 gezeigten analogen Auskopplung des Testsignals über den Ausgang 7 des Testgeräts 2, welcher mit dem Ausgang des Digital/Analog-Wandlers 5 des Testgeräts 2 verbunden ist, kann die in Fig. 1 gezeigte Laufzeitkompensationseinrichtung 15 entfallen, da in diesem Fall allenfalls von einer marginalen Phasenverschiebung in den beiden Testgeräten 2, 3 ausgegangen werden kann, wobei die Phasenverschiebung zudem in den Verstärkern 6, 11 der beiden Testgeräte 2, 3 gleich groß sein dürfte. Alternativ kann jedoch auch das in Fig. 2 gezeigte Ausführungsbeispiel um eine Laufzeitkompensation ähnlich zu dem in Fig. 1 gezeigten Ausführungsbeispiel ergänzt werden.

Ansonsten kann bezüglich Fig. 2 vollinhaltlich auf die obigen Ausführungen zu Fig. 1 verwiesen werden.

## Patentansprüche

1. Testgerät (2) zum Testen eines energietechnischen Prüflings (14), umfassend
einen Signalpfad mit Testsignal-Erzeugungsmitteln (4) zum Erzeugen eines Testsignals und mit Verstärkermitteln (6) zum Verstärken des Testsignals, um das verstärkte Testsignal über einen Ausgang zum Testen des energietechnischen Prüflings (14) auszugeben, und
einen zusätzlichen Ausgang (7) zum Auskoppeln des Testsignals aus dem Signalpfad und Ausgeben des Testsignals an ein weiteres Testgerät (3),
**dadurch gekennzeichnet,**
**dass** das Testgerät (2) derart ausgestaltet ist, dass es Abtastwerte des Testsignals über den zusätzlichen Ausgang (7) zusammen mit entsprechender Zeitinformation an das weitere Testgerät (3) zur Steuerung der zeitlichen Ausgabe dieser Abtastwerte durch das weitere Testgerät (3) ausgibt.

2. Testgerät (2) nach Anspruch 1,
**dadurch gekennzeichnet,**
**dass** der Signalpfad des Testgeräts (2) Digital/Analog-Wandlermittel (5) zwischen den Testsignal-Erzeugungsmitteln (4) und den Verstärkermitteln (6) aufweist, wobei das Testsignal über den zusätzlichen Ausgang (7) zwischen den Testsignal-Erzeugungsmitteln (4) und den Digital/Analog-Wandlermitteln (5) ausgekoppelt wird.

3. Testgerät (2) nach Anspruch 1,
**dadurch gekennzeichnet,**
**dass** der Signalpfad des Testgeräts (2) Digital/Analog-Wandlermittel (5) zwischen den Testsignal-Erzeugungsmitteln (4) und den Verstärkermitteln (6) aufweist, wobei das Testsignal über den zusätzlichen Ausgang (7) zwischen den Digital/Analog-Wandlermitteln (5) und den Verstärkermitteln (6) ausgekoppelt wird.

4. Testgerät (2) nach einem der Ansprüche 1-3,
**dadurch gekennzeichnet,**
**dass** der zusätzliche Ausgang (7) eine digitale Schnittstelle zum Auskoppeln des Testsignals an das weitere Testgerät (3) umfasst.

5. Testgerät (3) zum Testen eines energietechnischen Prüflings (14), umfassend
einen Signalpfad mit Testsignal-Erzeugungsmitteln (9) zum Erzeugen eines Testsignals und mit Verstärkermitteln (11) zum Verstärken des Testsignals, um das verstärkte Testsignal über einen Ausgang zum Testen des energietechnischen Prüflings (14) auszugeben, und
einen Eingang (12) zum Einspeisen eines von einem weiteren Testgerät (2) ausgekoppelten Testsignals in den Signalpfad und Ausgeben dieses von den Verstärkermitteln (11) des Signalpfads verstärkten Testsignals über den Ausgang zum Testen des energietechnischen Prüflings (14),
**dadurch gekennzeichnet,**
**dass** das Testgerät (3) Kompensationsmittel (15) zur Kompensation einer Laufzeit des von dem weiteren Testgerät (2) ausgekoppelten Testsignals aufweist, um dieses Testsignal an den energietechnischen Prüfling (14) zeitlich synchron zu dem von dem weiteren Testgerät (2) ebenfalls an den energietechnischen Prüfling (14) ausgegebenen Testsignal auszugeben.

6. Testgerät (3) nach Anspruch 5,
**dadurch gekennzeichnet,**
**dass** der Signalpfad des Testgeräts (3) Digital/Analog-Wandlermittel (10) zwischen den Testsignal-Erzeugungsmitteln (9) und den Verstärkermitteln (11) aufweist, wobei das Testsignal über den Eingang (12) zwischen den Testsignal-Erzeugungsmitteln (9) und den Digital/Analog-Wandlermitteln (10) eingespeist wird.

7. Testgerät (3) nach Anspruch 5,
**dadurch gekennzeichnet,**
**dass** der Signalpfad des Testgeräts (3) Digital/Analog-Wandlermittel (10) zwischen den Testsignal-Erzeugungsmitteln (9) und den Verstärkermitteln (11) aufweist, wobei das Testsignal über den Eingang (12) zwischen den Digital/Analog-Wandlermitteln (10) und den Verstärkermitteln (11) eingespeist wird.

8. Testgerät (3) nach einem der Ansprüche 5-7,
**dadurch gekennzeichnet,**
**dass** die Kompensationsmittel (15) derart ausgestaltet sind, dass sie die Laufzeit des Testsignals mit einem einstellbaren Korrekturwert kompensieren.

9. Testgerät (3) nach einem der Ansprüche 5-7,
**dadurch gekennzeichnet,**
**dass** die Kompensationsmittel (15) derart ausgestaltet sind, dass sie die Ausgabe von Abtastwerten des von dem weiteren Testgerät (2) ausgekoppelten und in den Signalpfad eingespeisten Testsignals an den energietechnischen Prüfling (14) zu Zeitpunkten veranlassen, welche den zusammen mit dem Testsignal von dem weiteren Testgerät (2) übertragenen Zeitinformationen entsprechen.

10. Testgerät (3) nach einem der Ansprüche 5-7,
**dadurch gekennzeichnet,**
**dass** die Kompensationsmittel (15) derart ausgestaltet sind, dass sie die Laufzeitkompensation durch Anwendung eines Verfahrens gemäß dem IEEE 1588-Standard oder durch Ausgabe von Abtastwerten des von dem weiteren Testgerät (2) ausgekoppelten und in den Signalpfad eingespeisten Testsignals zeitlich synchron zu einem Takt einer Schnittstelle, über welche das Testsignal von dem weiteren Testgerät (2) an das Testgerät (3) übertragen wird, an den energietechnischen Prüfling (14) durchführen.

11. Testgerät (3) nach einem der Ansprüche 5-10,
**dadurch gekennzeichnet,**
**dass** der Eingang (12) eine digitale Schnittstelle zum Einspeisen des Testsignals von dem weiteren Testgerät (2) in den Signalpfad umfasst.

12. Testgerät (2, 3) nach einem der Ansprüche 4 oder 11,
**dadurch gekennzeichnet,**
**dass** die digitale Schnittstelle eine Ethernet-Schnittstelle, eine USB-Schnittstelle, eine Ethercat-Schnittstelle oder eine Schnittstelle gemäß dem IEC 61850-Standard ist.

13. Testgerät (2, 3) nach einem der vorhergehenden Ansprüche,
**dadurch gekennzeichnet,**
**dass** das Testgerät (2, 3) zum Testen eines Betriebsmittels eines elektrischen Hoch- oder Mittelspannungssystems ausgestaltet ist.

14. Testsystem (1) zum Testen eines energietechnischen Prüflings (14), umfassend
ein erstes Testgerät (2) zum Testen des energietechnischen Prüflings (14), wobei das erste Testgerät (2) einen Signalpfad (4-6) zum Erzeugen eines Testsignals, Verstärken des Testsignals und Ausgeben des verstärkten Testsignals über einen Ausgang zum Testen des energietechnischen Prüflings (14) aufweist, und wobei das erste Testgerät (2) einen zusätzlichen Ausgang (7) zum Auskoppeln des Testsignals aus dem Signalpfad (4-6) des ersten Testgeräts (2) aufweist, wobei das Testgerät (2) derart ausgestaltet ist, dass es Abtastwerte des Testsignals über den zusätzlichen Ausgang (7) zusammen mit entsprechender Zeitinformation an ein zweites Testgerät (3) zur Steuerung der zeitlichen Ausgabe dieser Abtastwerte durch das zweite Testgerät (3) ausgibt, und
das zweites Testgerät (3) zum Testen des energietechnischen Prüflings (14), wobei das zweite Testgerät (3) einen Signalpfad (9-11) zum Erzeugen eines Testsignals, Verstärken des Testsignals und Ausgeben des verstärkten Testsignals über einen Ausgang zum Testen des energietechnischen Prüflings (14) aufweist, und wobei das zweite Testgerät einen Eingang (12) zum Einspeisen des über den zusätzlichen Ausgang (7) des ersten Testgeräts (2) ausgekoppelten Testsignals des ersten Testgeräts (2) in den Signalpfad (9-11) des zweiten Testgeräts (3) aufweist, um das Testsignal des ersten Testgeräts (2) zu verstärken und über den Ausgang des zweiten Testgeräts (3) zum Testen des energietechnischen Prüflings (14) auszugeben, wobei das zweite Testgerät (3) Kompensationsmittel (15) zur Kompensation einer Laufzeit des von dem ersten Testgerät (2) ausgekoppelten Testsignals aufweist, um dieses Testsignal an den energietechnischen Prüfling (14) zeitlich synchron zu dem von dem ersten Testgerät (2) ebenfalls an den energietechnischen Prüfling (14) ausgegebenen Testsignal auszugeben

15. Testsystem (1) nach Anspruch 14,
**dadurch gekennzeichnet,**
**dass** das erste Testgerät (2) ein Testgerät nach einem der Ansprüche 1-4 oder 11-13, sofern diese Ansprüche von den Ansprüchen 1-4 abhängig sind, ist,
und **dass** das zweite Testgerät (3) ein Testgerät nach einem der Ansprüche 5-10 oder 11-13, sofern diese Ansprüche von den Ansprüchen 5-10
abhängig sind, ist.

16. Verfahren zum Testen eines energietechnischen Prüflings (14), umfassend:
Erzeugen eines Testsignals mit Hilfe eines ersten Testgeräts (2), welches zum Testen des energietechnischen Prüflings (14) ausgestaltet ist,
Auskoppeln des Testsignals aus einem Signalpfad (4-6) des ersten Testgeräts (2),
Einspeisen des von dem ersten Testgerät (2) ausgekoppelten Testssignals in einen Signalpfad (9-11) eines zweiten Testgeräts (3), welches zum Testen des energietechnischen Prüflings (14) ausgestaltet ist,
Verstärken des eingespeisten Testsignals in dem Signalpfad (9-11) des zweiten Testgeräts (3), und
Ausgeben des verstärkten Testsignals über einen Ausgang des zweiten Testgeräts (3) zum Testen des energietechnischen Prüflings,
**dadurch gekennzeichnet,**
**dass** das Testsignal von dem zweiten Testgerät (3) zeitlich synchron zu dem von dem ersten Testgerät (2) ausgegebenen Testsignal ausgegeben wird.

17. Verfahren nach Anspruch 16,
**dadurch gekennzeichnet,**
**dass** das Testsignal in dem Signalpfad (4-6) des ersten Testgeräts (2) verstärkt und über einen Ausgang des ersten Testgeräts (2) zum Testen des energietechnischen Prüflings (14) ausgegeben wird.

18. Verfahren nach Anspruch 16 oder Anspruch 17,
**dadurch gekennzeichnet,**
**dass** das erste Testgerät (2) ein Testgerät nach einem der Ansprüche 1-4 oder 11-13, sofern diese Ansprüche von den Ansprüchen 1-4 abhängig sind, ist,
und **dass** das zweite Testgerät (3) ein Testgerät nach einem der Ansprüche 5-10 oder 11-13, sofern diese Ansprüche von den Ansprüchen 5-10 abhängig sind, ist.

## Claims

1. A test device (2) for testing a power engineering test object (14), comprising a signal path comprising test signal generation means (4) for generating a test signal and amplifier means (6) for amplifying the test signal to output the amplified test signal via an output for testing the power engineering test object (14), and
an additional output (7) for decoupling the test signal from the signal path and for outputting the test signal to a further test device (3),
**characterized in that**
the test device (2) is configured such that it outputs sample values of the test signal together with corresponding time information via the additional output (7) to the further test device (3) to control the timewise output of these sample values by the further test device (3).

2. The test device (2) according to claim 1,
**characterized in that**
the signal path of the test device (3) comprises digital-to-analog converter means (5) between the test signal generator means (4) and the amplifier means (6), the test signal being decoupled via the additional output (7) between the test signal generator means (4) and the digital-to-analog converter means (5).

3. The test device (2) according to claim 1,
**characterized in that**
the signal path of the test device (2) comprises digital-to-analog converter means (5) between the test signal generator means (4) and the amplifier means (6), the test signal being decoupled via the additional output (7) between the digital-to-analog converter means (5) and the amplifier means (6).

4. The test device (2) according to any one of claims 1-3
**characterized in that**
the additional output (7) comprises a digital interface for decoupling the test signal to the further test device (3).

5. A test device (3) for testing a power engineering test object (14), comprising a signal path comprising test signal generation means (9) for generating a test signal and amplifier means (11) for amplifying the test signal to output the amplified test signal via an output for testing the power engineering test object (14), and
an input (12) for supplying a test signal decoupled from a further test device (2) to the signal path and for outputting this test signal amplified by the amplifier means (11) of the signal path via the output for testing the power engineering test object (14), **characterized in that**
the test device (3) comprises compensation means (15) for compensating for a signal run time of the test signal decoupled from the further test device (2) to output this test signal in a time-synchronous manner with the test signal output to the power engineering test object (14) by the further test device (2).

6. The test device (3) according to claim 5,
**characterized in that**
the signal path of the test device (3) comprises digital-to-analog converter means (10) between the test signal generator means (9) and the amplifier means (11), the test signal being supplied via the input (12) between the test signal generator means (9) and the digital-to-analog converter means (10).

7. The test device (3) according to claim 5,
**characterized in that**
the signal path of the test device (3) comprises digital-to-analog converter means (10) between the test signal generator means (9) and the amplifier means (11), the test signal being supplied via the input (12) between the digital-to-analog converter means (10) and the amplifier means (11).

8. The test device (3) according to any one of claims 5-7,
**characterized in that**
the compensation means (15) are configured such that they compensate for the run time of the test signal by means of an adjustable correction value.

9. The test device (3) according to any one of claims 5-7,
**characterized in that**
the compensation means (15) are configured such that they cause the output of sample values of the test signal decoupled from the further test device (2) and supplied to the signal path to the power engineering test object (14) at time points that correspond to the time information transmitted together with the test signal by the further test device (2).

10. The test device (3) according to any one of claims 5-7,
**characterized in that**
the compensation means (15) are configured such that they perform the run time compensation by application of a method according to the IEEE 1588 standard, or by outputting sample values of the test signal decoupled from the further test device (2) and supplied to the signal path time-synchronously with a clock of an interface, via which the test signal is transmitted by the further test device (2) to the test device (3), to the power engineering test object (14).

11. The test device (3) according to any one of claims 5-10,
**characterized in that**,
the input (12) comprises a digital interface for supplying the test signal from the further test device (2) to the signal path.

12. The test device (2, 3) according to claim 4 or claim 11,
**characterized in that**
the digital interface is an Ethernet interface, a USB interface, an Ethercat interface, or an interface according to the IEC 61850 standard.

13. The test device (2, 3) according to any one of the preceding claims,
**Characterized in that**
the test device (2, 3) is configured for testing an operating resource of an electrical high voltage or medium voltage system.

14. A test system (1) for testing a power engineering test object (14), comprising a first test device (2) for testing the power engineering test object (14), wherein the first test device (2) comprises a signal path (4-6) for generating a test signal, amplifying the test signal and outputting the amplified test signal via an output for testing the power engineering test object (14), and wherein the first test device (2) comprises an additional output (7) for decoupling the test signal from the signal path (4-6) of the first test device (2), wherein the test device (2) is configured such that it outputs sample values of the test signal together with corresponding time information via the additional output (7) to a second test device (3) to control the timewise output of these sample values by the second test device (3), and
the second test device (3) for testing the power engineering test object (14), wherein the second test device (3) comprises a signal path (9-11) for generating a test signal, amplifying the test signal and outputting the amplified test signal via an output for testing the power engineering test object (14), and wherein the second test device (3) comprises an input for supplying the test signal decoupled via the additional output (7) of the first test device (2) to the signal path (9-11) of the second test device (3) to amplify and output via the output of the second test device (3) the test signal of the first test device (2) for testing the power engineering test object (14), wherein the second test device (3) comprises compensation means (15) for compensating for a signal run time of the test signal decoupled from the first test device (2) to output this test signal to the power engineering test object (14) in a time-synchronous manner with the test signal which is also output to the power engineering test object (14) by the first test device (2).

15. The test system (1) according to claim 14,
**characterized in that**
the first test device (2) is a test device according to any one of claims 1-4 or 11-13, as far as these claims depend from claims 1-4, and
the second test device (3) is a test device according to any one of claims 5-10 or 11-13, as far as these claims depend from claims 5-10.

16. A method for testing a power engineering test object (14), comprising generating a test signal by means of a first test device (2) which is configured for testing the power engineering test object (14),
decoupling the test signal from a signal path (4-6) of the first test device (2), supplying the test signal decoupled from the first test device (2) to a signal path (9-11) of a second test device (3) which is configured for testing the power engineering test object (14),
amplifying the test signal supplied to the signal path (9-11) of the second test device (3), and
outputting the amplified test signal via an output of the second test device (3) for testing the power engineering test object (14),
**characterized in that**
the test signal is output by the second test device (3) time-synchronously with the test signal output by the first test device (2).

17. The method according to claim 16,
**characterized in that**
the test signal is amplified in the signal path (4-6) of the first test device (2) and is output via an output of the first test device (2) for testing the power engineering test object (14).

18. The method according to claim 18,
**characterized in that**
the first test device (2) is a test device according to any one of claims 1-4 or 11-13, as far as these claims depend from claims 1-4, and
the second test device (3) is a test device according to any one of claims 5-10 or 11-13, as far as these claims depend from claims 5-10.

## Revendications

1. Appareil de test (2) servant à tester un échantillon technique de production d'énergie (14), comprenant un chemin de signal pourvu de moyens de production de signal de test (4) servant à produire un signal de test et pourvu de moyens amplificateurs (6) servant à amplifier le signal de test afin de fournir le signal de test amplifié par l'intermédiaire d'une sortie afin de tester l'échantillon technique de production d'énergie (14), et
une sortie supplémentaire (7) servant à découpler le signal de test du chemin de signal et à fournir le signal de test à un autre appareil de test (3),
**caractérisé en ce**
**que** l'appareil de test (2) est configuré de telle manière qu'il fournit des valeurs de balayage du signal de test, par l'intermédiaire de la sortie supplémentaire (7), conjointement avec une information de temps correspondante, à l'autre appareil de test (3) aux fins de la commande de la fourniture dans le temps desdites valeurs de balayage par l'autre appareil de test (3).

2. Appareil de test (2) selon la revendication 1,
**caractérisé en ce**
**que** le chemin de signal de l'appareil de test (2) présente, entre les moyens de production de signal de test (4) et les moyens amplificateurs (6), des moyens de conversion numérique/analogique (5), sachant que le signal de test est découplé par l'intermédiaire de la sortie supplémentaire (7) entre les moyens de production de signal de test (4) et les moyens de conversion numérique/analogique (5).

3. Appareil de test (2) selon la revendication 1,
**caractérisé en ce**
**que** le chemin de signal de l'appareil de test (2) présente des moyens de conversion numérique/analogique (5) entre les moyens de production de signal de test (4) et les moyens amplificateurs (6), sachant que le signal de test est découplé, par l'intermédiaire de la sortie supplémentaire (7), entre les moyens de conversion numérique/analogique (5) et les moyens amplificateurs (6).

4. Appareil de test (2) selon l'une quelconque des revendications 1 à 3,
**caractérisé en ce**
**que** la sortie supplémentaire (7) comprend une interface numérique servant à découpler le signal de test et à l'envoyer à l'autre appareil de test (3).

5. Appareil de test (3) servant à tester un échantillon technique de production d'énergie (14), comprenant
un chemin de signal pourvu de moyens de production de signal de test (9) servant à produire un signal de test et pourvu de moyens amplificateurs (11) servant à amplifier le signal de test afin de fournir le signal de test amplifié par l'intermédiaire de la sortie afin de tester l'échantillon technique de production d'énergie (14), et
une entrée (12) servant à injecter un signal de test découplé d'un appareil de test (2) supplémentaire dans le chemin de signal et servant à émettre ledit signal de test amplifié par les moyens amplificateurs (11) du chemin de signal par l'intermédiaire de la sortie afin de tester l'échantillon technique de production d'énergie (14),
**caractérisé en ce**
**que** l'appareil de test (3) présente des moyens de compensation (15) aux fins de la compensation d'une durée de propagation du signal de test découplé de l'autre appareil de test (2) afin de fournir ledit signal de test à l'échantillon technique de production d'énergie (14) de manière synchrone dans le temps par rapport au signal de test fourni par l'autre appareil de test (2) également à l'échantillon technique de production d'énergie (14).

6. Appareil de test (3) selon la revendication 5,
**caractérisé en ce**
**que** le chemin de signal de l'appareil de test (3) présente des moyens de conversion numérique/analogique (10) entre les moyens de production de signal de test (9) et les moyens amplificateurs (11), sachant que le signal de test est injecté par l'intermédiaire de l'entrée (12) entre les moyens de production de signal de test (9) et les moyens de conversion numérique/analogique (10).

7. Appareil de test (3) selon la revendication 5,
**caractérisé en ce**
**que** le chemin de signal de l'appareil de test (3) présente des moyens de conversion numérique/analogique (10) entre les moyens de production de signal de test (9) et les moyens amplificateurs (11), sachant que le signal de test est injecté par l'intermédiaire de l'entrée (12) entre les moyens de conversion numérique/analogique (10) et les moyens amplificateurs (11) .

8. Appareil de test (3) selon l'une quelconque des revendications 5 à 7,
**caractérisé en ce**
**que** les moyens de compensation (15) sont configurés de telle manière qu'ils compensent le temps de propagation du signal de test à l'aide d'une valeur de correction ajustable.

9. Appareil de test (3) selon l'une quelconque des revendications 5 à 7,
**caractérisé en ce**
**que** les moyens de compensation (15) sont configurés de telle manière qu'ils entraînent, par intermittence, la sortie de valeurs de balayage du signal de test découplé de l'autre appareil de test (2) et injecté dans le chemin de signal pour les envoyer à l'échantillon technique de production d'énergie (14), qui correspondent aux informations temporelles transmises conjointement avec le signal de test par l'autre appareil de test (2).

10. Appareil de test (3) selon l'une quelconque des revendications 5 à 7,
**caractérisé en ce**
**que** les moyens de compensation (15) sont configurés de telle manière qu'il exécutent la compensation du temps de propagation en utilisant le procédé selon le protocole IEEE 1588 ou en fournissant à l'échantillon technique de production d'énergie (14) des valeurs de balayage du signal de test découplé de l'autre appareil de test (2) et injecté dans le chemin de signal de manière synchrone dans le temps par rapport à une cadence d'une interface, laquelle permet de transférer le signal de test de l'autre appareil de test (2) à l'appareil de test (3).

11. Appareil de test (3) selon l'une quelconque des revendications 5 à 10,
**caractérisé en ce**
**que** l'entrée (12) comprend une interface numérique servant à injecter le signal de test en provenance de l'autre appareil de test (2) dans le chemin de signal.

12. Appareil de test (2, 3) selon l'une quelconque des revendications 4 ou 11,
**caractérisé en ce**
**que** l'interface numérique est une interface éthernet, une interface USB, une interface Ethercat ou une interface selon la norme IEC 61850.

13. Appareil de test (2, 3) selon l'une quelconque des revendications précédentes,
**caractérisé en ce**
**que** l'appareil de test (2, 3) est configuré pour tester un moyen de fonctionnement d'un système électrique à haute ou moyenne tension.

14. Système de test (1) servant à tester un échantillon technique de production d'énergie (14), comprenant
un premier appareil de test (2) servant à tester l'échantillon technique de production d'énergie (14), sachant que le premier appareil de test (2) présente un chemin de signal (4 - 6) servant à produire un signal de test, à amplifier le signal de test et à fournir le signal de test amplifié par l'intermédiaire d'une sortie afin de tester l'échantillon technique de production d'énergie (14), et sachant que le premier appareil de test (2) présente une sortie supplémentaire (7) servant à découpler le signal de test du chemin de signal (4 - 6) du premier appareil de test (2), sachant que l'appareil de test (2) est configuré de telle manière qu'il fournit des valeurs de balayage du signal de test par l'intermédiaire de la sortie supplémentaire (7), conjointement avec une information temporelle correspondante, à un deuxième appareil de test (3) afin de commander la fourniture dans le temps desdites valeurs de balayage par le deuxième appareil de test (3), et
le deuxième appareil de test (3) servant à tester l'échantillon de production d'énergie (14), sachant que le deuxième appareil de test (3) présente un chemin de signal (9 - 11) servant à produire un signal de test, à amplifier le signal de test et à fournir le signal de test amplifié par l'intermédiaire d'une sortie afin de tester l'échantillon technique de production d'énergie (14), et sachant que le deuxième appareil de test présente une entrée (12) servant à injecter le signal de test, découplé par l'intermédiaire de la sortie supplémentaire (7) du premier appareil de test (2), du premier appareil de test (2) dans le chemin de signal (9 - 11) du deuxième appareil de test (3) afin d'amplifier le signal de test du premier appareil de test (2) et de fournir ce dernier par l'intermédiaire de la sortie du deuxième appareil de test (3) afin de tester l'échantillon technique de production d'énergie (14), sachant que le deuxième appareil de test (3) présente des moyens de compensation (15) servant à la compensation d'un temps de propagation du signal de test découplé du premier appareil de test (2) afin de fournir ledit signal de test à l'échantillon technique de production d'énergie (14) de manière synchrone dans le temps par rapport au signal de test fourni par le premier appareil de test (2) de la même manière à l'échantillon technique de production d'énergie (14).

15. Système de test (1) selon la revendication 14,
**caractérisé en ce**
**que** le premier appareil de test (2) est un appareil de test selon l'une quelconque des revendications 1 à 4 ou 11 à 13, dans la mesure où lesdites revendications sont dépendantes des revendications 1 à 4,
et en ce que le deuxième appareil de test (3) est un appareil de test selon l'une quelconque des revendications 5 à 10 ou 11 à 13, dans la mesure où lesdites revendications sont dépendantes des revendications 5 à 10.

16. Procédé servant à tester un échantillon technique de production d'énergie (14), comprenant les étapes suivantes consistant à :
produire un signal de test à l'aide d'un premier appareil de test (2), qui est configuré pour tester l'échantillon technique de production d'énergie (14) ;
découpler le signal de test du chemin de signal (4 - 6) du premier appareil de test (2) ;
injecter le signal de test découplé du premier appareil de test (2) dans un signal de chemin (9 - 11) d'une deuxième appareil de test (3), qui est configuré pour tester l'échantillon technique de production d'énergie (14) ;
amplifier le signal de test injecté dans le chemin de signal (9 - 11) du deuxième appareil de test (3) ; et
fournir le signal de test amplifié par l'intermédiaire d'une sortie du deuxième appareil de test (3) afin de tester l'échantillon technique de production d'énergie,
**caractérisé en ce**
**que** le signal de test est fourni par le deuxième appareil de test (3) de manière synchrone dans le temps par rapport au signal de test fourni par le premier appareil de test (2).

17. Procédé selon la revendication 16,
**caractérisé en ce**
**que** le signal de test est amplifié dans le chemin de signal (4 - 6) du premier appareil de test (2) et fourni par l'intermédiaire d'un sortie du premier appareil de test (2) afin de tester l'échantillon technique de production d'énergie (14).

18. Procédé selon la revendication 16 ou la revendication 17,
**caractérisé en ce**
**que** le premier appareil de test (2) est un appareil de test selon l'une quelconque des revendications 1 à 4 ou 11 à 13 dans la mesure où lesdites revendications sont dépendantes des revendications 1 à 4,
et en ce que le deuxième appareil de test (3) est un appareil de test selon l'une quelconque des revendications 5 à 10 ou 11 à 13, dans la mesure où lesdites revendications sont dépendantes des revendications 5 à 10.
